Europäisches Patentamt

European Patent Office

Office européen des brevets

(19)

(11) **EP 1 457 979 A2**

(12) # EUROPEAN PATENT APPLICATION

(43) Date of publication:
**15.09.2004 Bulletin 2004/38**

(51) Int Cl.⁷: **G11B 7/26**

(21) Application number: **04003528.9**

(22) Date of filing: **17.02.2004**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **28.02.2003 JP 2003052962**

(71) Applicant: **Pioneer Corporation
Meguro-ku, Tokyo (JP)**

(72) Inventor: **Katsumura, Masahiro,
Corp. Research & Dev. Labor.
Tsurugashima-shi Saitama 350-2288 (JP)**

(74) Representative:
**Manitz, Finsterwald & Partner GbR
Postfach 31 02 20
80102 München (DE)**

(54) **Electron beam recording substrate**

(57)     An electron beam recording substrate (S) which holds a resist film (R) where electron beam information recording is carried out and which has a surface layer area (40) made of a material that suppresses enlargement of a scattering distribution diameter of electrons spread inside by irradiation of an electron beam from a resist film side.

## FIG.4

EP 1 457 979 A2

**Description**

BACKGROUND OF THE INVENTION

1. Field of the Invention

The present invention relates to an electron beam recording substrate which holds a resist film where electron beam information recording is carried out.

2. Description of the Related Art

Information recording by an electron beam has been used in writing masks for semiconductor devices in order to improve the precision of line widths. At the time of executing electron beam exposure in the fabrication process of semiconductor devices, an electron sensitive material is applied on a semiconductor substrate and an electron beam is directly irradiated on the electron sensitive material with the semiconductor substrate grounded.

With regard to the fabrication of recording media which have higher densities than the density of DVDs (Digital Versatile Discs), information recording apparatuses which use an electron beam have been developed (see Japanese Unexamined Patent Publication No. Hei 6-131706 (Patent No. 3040887), for example). Optical discs or the like are formed by forming a stamper from a master disc acquired by exposing a resist film, made of an electron sensitive material coated on a disc substrate, with an electron beam to thereby form and record a latent image of track pattern information, and performing injection-molding with a synthetic resin using the stamper (see Japanese Unexamined Patent Publication No. 2002-230847, for example).

In the exposure system for mask fabrication and information recording apparatus using an electron beam, the latent image on the resist film can be made finer by increasing the acceleration voltage in an electron gun.

However, the increase in acceleration voltage leads a problem of lowering the sensitivity of the resist film for the following reason. As the acceleration voltage increases, the influence of forward scattering in the resist film becomes smaller, improving the contrast of the electron energy. This improves the resolution and the size controllability. However, electrons directly pass in the resist film, which lowers the sensitivity of the electron sensitive material.

SUMMARY OF THE INVENTION

Accordingly, it is an object of the invention to provide an electron beam recording substrate which can achieve a high sensitivity for a resist film.

To achieve the above object, an electron beam recording substrate according to the invention holds a resist film where electron beam information recording is carried out and has a surface layer area made of a material that suppresses enlargement of a scattering distribution diameter of electrons spread inside by irradiation of an electron beam from a resist film side.

BRIEF DESCRIPTION OF THE DRAWINGS

Fig. 1 is a schematic block diagram illustrating an electron beam recorder using a beam according to the invention; and

Figs. 2 to 6 are schematic cross-sectional views partially enlarged each showing a portion of a master disc which uses an electron beam recording substrate according to the invention.

DETAILED DESCRIPTION OF THE INVENTION

The following will describe, as one example, a case where information is recorded on a master disc with an electron beam using an electron beam recording substrate (hereinafter called "substrate") referring to the accompanying drawings.

This master disc is an information recording medium which becomes a master in fabricating high-density optical discs and is adapted to mastering technology using an electron beam. The outline of the electron beam mastering is such that a resist film is coated on an electron beam recording substrate, and then an electron beam exposure to directly irradiate an electron beam onto the resist film is performed, and then the exposed portion of the resist film is removed (formation of positive) by a developing process, thereby forming pits or grooves as recorded information on the resist film.

<Information Recording Apparatus>

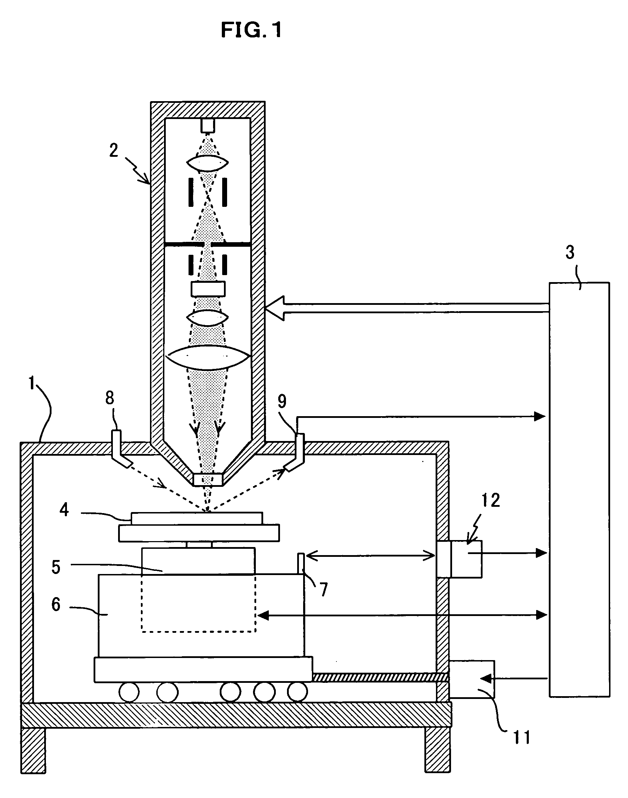

Fig. 1 is a schematic block diagram illustrating the structure of an electron beam recorder or an information recording apparatus in electron beam mastering. The electron beam recorder comprises a vacuum chamber 1, an electron beam column 2 provided perpendicularly with respect to the vacuum chamber 1, and a controller 3.

Provided in the vacuum chamber 1 are a spindle motor 5 which turns a master disc 4 while keeping it horizontal, a movable stage 6 which moves the spindle motor 5 back and forth in a predetermined direction, a mirror 7 attached to one end of the movable stage 6 and photosensors 8 and 9 for detecting the focal position of an electron beam. The master disc 4 placed on the turn table of the spindle motor 5 has a resist film deposited on that side of the electron beam column 2.

The spindle motor 5 is controlled by the controller 3 in such a way as to rotate at a constant linear velocity at the time of electron beam exposure. The movable stage 6 is moved horizontally by the controller 3 upon reception of the driving force of an external electric motor 11. A distance measuring unit 12 which irradiates a laser beam on the mirror 7 and detects reflected light, detects the moving position of the movable stage 6 and supplies the position to the controller 3. The controller 3 performs feedback control of the movable stage 6.

The electron beam column 2 comprises an electron gun, a condenser lens, a blanking electrode, an aperture, a deflection electrode, a focus lens, an objective lens, etc. Under the control of the controller 3, the electron beam column 2 deflects electrons, radiated from the electron gun as an electron beam, via the condense lens and blanking electrode, performs beam modulation according to recorded information, adjusts the position by the deflection electrode, sets the focal distance by the focus lens, restricts the beam narrower by the objective lens, and irradiates the beam on the surface of the master disc 4. That is, the controller 3 performs the ON/OFF control and positional adjustment of the electron beam and focus control of the electron beam according to the irradiation position detection information from the photosensors 8 and 9.

At the time of recording with an electron beam, as the spindle motor 5 and movable stage 6 are driven while irradiating the electron beam onto the surface of the thin film of the master disc 4, the master disc 4 is scanned with the electron beam. Accordingly, the resist film is exposed with the electron beam based on recorded information, and a latent image for minute recesses and projections, such as prepits and grooves, is formed on the resist film by the locus of the electron beam spot.

<Electron Beam Recording Substrate of Master Disk>

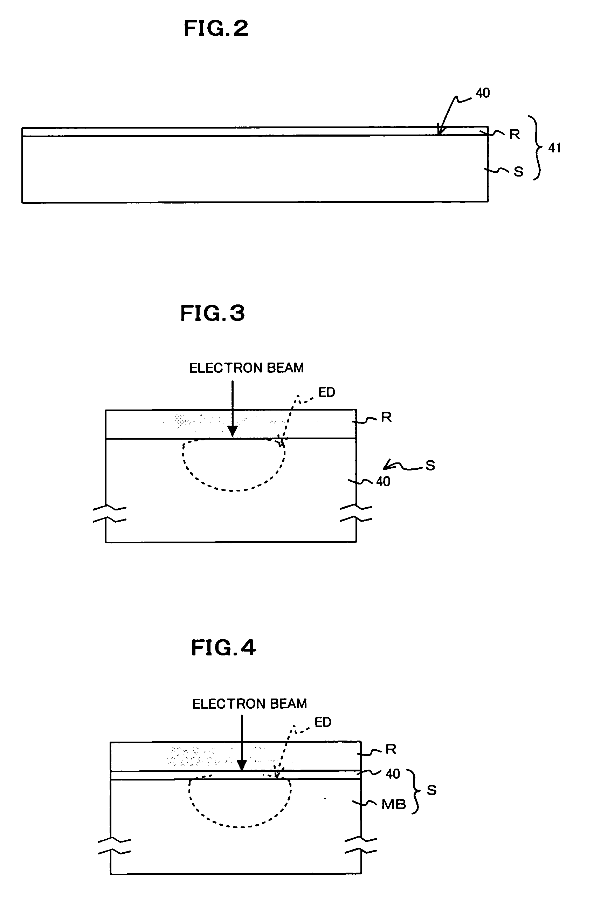

Fig. 2 is a schematic cross-sectional views showing the structure of the master disc 4. The master disc 4 comprises an electron beam recording substrate (hereinafter called "substrate") S and a resist film R which is held on the substrate S and where information is recorded with an electron beam. The resist film R is coated by, for example, spin coating. The substrate S has a surface layer area 40 made of a material which suppresses enlargement of the scattering distribution ED diameter of electrons spread inside by irradiation of an electron beam from the resist film (R) side.

As shown in Fig. 3, the surface layer area 40 is in contact with the resist film R formed as a surface layer of a substrate main body MB in the substrate S.

As shown in Fig. 4, the entire substrate main body in contact with the resist film R can be made of a single material same as the material for the surface layer area 40, so that the surface layer area 40 itself can be made as a substrate.

In consideration of the influence of the amount of energy stored in the resist film on the dissolving of a later developing process (in case of positive) or solidification (in case of negative) at the time an electron beam would be irradiated on the resist film on the substrate, the present inventor studied the influence of the scattering distribution of electrons in the substrate on the amount of stored energy. The present inventor further discovered that the amount of stored energy, which would spread in the resist film due to scattering of input electrons, would be influenced by the scattering distribution of the electron beam, which passed the resist film, in the substrate.

As electrons enter the substrate, they are elastically scattered with the nucleus of atoms constituting the substrate or perform non-elastic scattering with electrons constituting the substrate, thus increasing the width of the electron beam. Because part of the energy of the input electrons is given to the mating atoms or because of damping radiation discharge, the energy of electrons becomes smaller.

Accordingly, the present inventor calculated the locus of electrons in the substrate through actual simulation and confirmed that the scattering distribution size over which the locus of electrons would be widened would vary significantly depending on the energy of the electron beam and the atomic number, density, etc. of a solid.

An average distance $\lambda$ over which electrons travel before they undergo single scattering is expressed by the following equation.

$$\lambda = \frac{1}{n\Sigma} = \frac{A}{N_A \rho \Sigma}$$

In the above equation, n is the number of atoms per unit volume, $\Sigma$ is the scattering total cross-sectional area, $N_A$ is the Avogadro constant = 6.02 x $10^{23}$, P is the atomic density and A is the atomic weight.

In the above equation, the scattering total cross-sectional area $\Sigma$ is given by Murata et al. (1971) by the following equation which takes non-elastic scattering effect into consideration.

$$\Sigma = \frac{nZ(Z+1)e^4}{4\beta(\beta+1)E^2}$$

In the above equation, Z is the atomic number, e is the charge of electrons = -4.08029 x $10^{-10}$ esu, E is the kinetic energy of electrons = eV/300 (V being the acceleration voltage) and $\beta$ is a screening parameter.

In the above equation, the screening parameter b is given by Nigam et al. (1959) by the following equation.

$$\beta = \frac{5.44}{V} Z^{\frac{2}{3}}$$

It is apparent from the above that the average distance $\lambda$ over which electrons travel before they undergo single scattering depends on the atomic number Z, the atomic density $\rho$, the atomic weight A and the acceleration voltage V.

With the substrate including the surface layer area being made of a single material of magnesium (Mg), silicon (Si), titanium (Ti), nickel (Ni), ruthenium (Ru) and gold (Au), the locus of electrons in the surface layer area of the substrate and the electron beam energy which would reach the surface was simulated. The simulation was conducted under the conditions that the acceleration voltage V was 50 kV, the physical property values of the substrate's material were expressed by "element name (Z: atomic number, A: atomic weight, $\rho$: atomic density)" and were specifically given as Mg (Z: 12, A: 24.312, $\rho$: 1.738), Si (Z: 14, A: 28.086, $\rho$: 2.33), Ti (Z: 22, A: 47.90, $\rho$: 4.50), Ni (Z: 28, A: 58.71, $\rho$: 8.908), Ru (Z: 44, A: 101.07, $\rho$: 12.41) and Au (Z: 79, A: 196.97, $\rho$: 19.32). The average distance $\lambda$ (element) over which electrons would travel before undergoing single scattering was $\lambda$ (Mg) = 130.19 $\mu$m, $\lambda$ (Si) = 92.359 $\mu$ m, $\lambda$ (Ti) = 45.751 $\mu$m, $\lambda$ (Ni) = 20.731 $\mu$m, $\lambda$ (Ru) = 14.2 $\mu$ m and $\lambda$ (Au) = 8.227 $\mu$m.

Consequently, it was confirmed that the use of the element with a small average distance $\lambda$ (high scattering effect) for the surface layer area of the substrate would lower the scattered beam energy dispersion at the top layer of the surface layer area of the substrate, thus making it possible to reduce the range of the influence of the scattered beam which reaches the surface layer area of the substrate. In addition to this result, high scattering-effect elements having a smaller average distance $\lambda$ than Si, i.e., materials which suppress enlargement of the scattering distribution diameter, ED, of electrons spread inside the substrate by irradiation of the electron beam are shown in Table 1 below.

Table 1

| atomic number ELEMENT | $\lambda$ | atomic number ELEMENT | $\lambda$ | atomic number ELEMENT | $\lambda$ |
|---|---|---|---|---|---|
| $^{13}$Al | 84.119 | $^{38}$Sr | 70.383 | $^{56}$Ba | 48.191 |
| $^{21}$Sc | 68.732 | $^{39}$Y | 40.624 | $^{57}$La | 28.053 |
| $^{22}$Ti | 45.751 | $^{40}$Zr | 27.698 | $^{72}$Hf | 12.232 |
| $^{23}$V | 33.837 | $^{41}$Nb | 20.735 | $^{73}$Ta | 9.7339 |
| $^{24}$Cr | 27.779 | $^{42}$Mo | 17.397 | $^{74}$W | 8.3801 |
| $^{25}$Mn | 26.905 | $^{43}$Tc | 15.469 | $^{75}$Re | 7.6558 |
| $^{26}$Fe | 24.562 | $^{44}$Ru | 14.2 | $^{76}$Os | 7.1793 |
| $^{27}$Co | 21.836 | $^{45}$Rh | 14.039 | $^{77}$Ir | 7.0959 |
| $^{28}$Ni | 20.731 | $^{46}$Pd | 14.56 | $^{78}$Pt | 7.4638 |
| $^{29}$Cu | 21.314 | $^{47}$Ag | 16.428 | $^{79}$Au | 8.227 |

Table 1   (continued)

| atomic number ELEMENT | λ | atomic number ELEMENT | λ | atomic number ELEMENT | λ |
|---|---|---|---|---|---|
| $^{30}$Zn | 26.354 | $^{48}$Cd | 20.213 | $^{80}$Hg | 11.752 |
| $^{31}$Ga | 32.54 | $^{49}$In | 23.78 | $^{81}$Tl | 13.465 |
| $^{32}$Ge | 36.055 | $^{50}$Sn | 24.069 | $^{82}$Pb | 14.023 |
| $^{33}$As | 33.211 | $^{51}$Sb | 26.138 | $^{83}$Bi | 16.208 |
| $^{34}$Se | 40.271 | $^{52}$Te | 28.651 | | |
| $^{35}$Br | 60.631 | $^{53}$I | 35.151 | | |
| $^{36}$Kr | 50.898 | $^{54}$Xe | 29.718 | | |

Therefore, it is preferable that the entire substrate main body which is in contact with the resist film R as shown in Fig. 4 can be made of a single material and the substrate main body with the surface layer area 40 alone should be made of a material containing at least one of elements with atomic numbers 21 to 36, 38 to 54, 57 and 72 to 83 by 50 wt% or greater.

As shown in Fig. 3, while the surface layer area 40 of the substrate S is formed as the surface layer of the substrate main body MB and is in contact with the resist film R, it is apparent that the thickness of the surface layer area 40 may or may not exceed the diameter (depth) of the scattering distribution diameter ED. In the case where the thickness of the surface layer area 40 exceeds the diameter (depth) of the scattering distribution diameter ED, it is preferable that the surface layer area 40 should be made of a material containing at least one of elements with atomic numbers 73 to 79 by 50 wt% or greater and the substrate main body MB should be made of a material containing at least one of elements with atomic numbers 13, 14, 21 to 36, 38 to 54, 56, 57, 72 and 80 to 83 by 50 wt% or greater. This is because the use of such an element can enhance the scattering effect of the surface layer area 40.

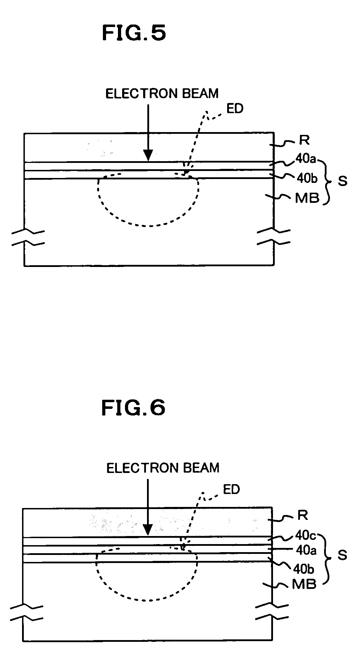

As another embodiment, the surface layer area 40 of the substrate can be constructed by plural layers of thin films, as shown in Fig. 5. In this case, it is preferable that, of the plurality of thin films of the surface layer area 40, at least one scattering layer 40a which is formed of an element with a high scattering effect should be made of a material containing at least one of elements with atomic numbers 21 to 36, 38 to 54, 56, 57, 72 to 83, more particularly, atomic numbers 73 to 79, by 50 wt% or greater. In this case, it is preferable that the element for a thin film 40b (auxiliary layer) other than the scattering layer 40a in the plurality of thin films of the surface layer area 40 should be selected from elements with a smaller average distance of λ than the element for the scattering layer 40a. For example, the scattering layer 40a is made of a material containing at least one of elements with atomic numbers 73 to 79 by 50 wt% or greater and the other thin films are made of a material containing at least one of elements with atomic numbers 21 to 36, 38 to 54, 56, 57, 72 and 80 to 83 by 50 wt% or greater.

As shown in Fig. 5, the scattering layer 40a in the surface layer area may be laid out in such a way as to contact the resist film.

To check the effect of such contact scattering layer, simulation on the λ ratio was carried out under the conditions that the substrate main body was of silicon, the surface layer area with a double layer structure was formed by depositing a chromium (Cr) layer on the silicon substrate main body and further depositing a scattering layer of Au on the chromium layer, the thickness of the chromium layer was set constant to 100 nm, the thickness of the Au scattering layer was varied from 300 nm, to 600 nm and 1000 nm and the average distance λ for the thickness of the Au scattering layer of 300 nm was set to 100. The results are given in the following Table 2.

Table 2

| Au film thickness | λ ratio |
|---|---|
| 300 nm | 100 |
| 600 nm | 75 |
| 1000 nm | 50 |

It is apparent that forming the Au layer thicker decreases the λ ratio or makes λ smaller. It was found that forming the scattering layer made of an element with a small average distance 1, such as Au, thinner would reduce the energy dispersion of the surface layer area of the substrate.

It is seen that as the scattering layer containing an element with a smaller average distance λ than silicon is used, it is possible to positively cause scattering of the electron beam that has entered the surface layer area of the substrate. At this time, it is difficult for the electrons to enter the surface layer area of the substrate so that a lot more scattered beam is concentrated on the surface layer area of the substrate, particularly, the scattering layer. This makes it possible to increase the number of electrons that contribute to the resist film formed on the surface layer area of the substrate. The increased electrons can enhance the sensitivity of the resist film. Therefore, the most desirable element to be used for the scattering layer of the surface layer area of the substrate is a compound which essentially consists (50 wt% or more) of an element with the same atomic number as one of the atomic numbers 73 to 79 and the next candidate is a compound which essentially consists (50 wt% or more) of an element with the same atomic number as one of the atomic numbers 21 to 36, 38 to 54, 57, 72 and 80 to 83.

As apparent from the above, the scattering layer of the surface layer area has a function of reducing the energy intensity of electrons scattered in the element with one of the atomic numbers 73 to 79 or its compound, resulting in a reduction in the electron energy which reaches the resist film and an improvement on the sensitivity.

Although the foregoing description of the embodiment has discussed a multilayer surface layer area which has the scattering layer 40a in contact with the resist film and another thin film 40b, the multilayer surface layer area can be structured as another embodiment in such a way that as shown in Fig. 6, a further thin film 40c is provided between the scattering layer 40a and the resist film R and is made in contact with the resist film to avoid direct contact between the scattering layer and the resist film.

To check the effect of the non-contact scattering layer, simulation on the $\lambda$ ratio was carried out on a non-contact sample with a double layer structure formed by depositing a scattering layer of Au with a thickness of 600 nm on the silicon substrate main body and depositing only a chromium layer with a thickness of 600 nm on the Au scattering layer and a contact sample having only a scattering layer of Au with a thickness of 600 nm on the silicon substrate main body in the case where the average distance $\lambda$ for the contact sample was set to 100. The results are given in the following Table 3.

Table 3

| Sample | $\lambda$ ratio |
|---|---|
| Contact | 100 |
| Non-contact | 75 |

It is seen that the $\lambda$ ratio is reduced, i.e., $\lambda$ becomes smaller by forming the chromium layer to make the Au scattering layer into a non-contact type. Further, the simulation showed that while electrons passing the chromium layer scattered, the scattering distribution of electrons passing the Au scattering layer became smaller and the electrons scattered in the silicon substrate main body, i.e., the scattering distribution of electrons became narrower at the Au scattering layer. Therefore, it was confirmed that placing the scattering layer containing an element with a small average distance 1, such as Au, in a middle of the lamination structure would allow the scattering layer to function as a filter and would reduce the energy dispersion of the surface layer area of the substrate. As the electron beam which has scattered by the scattering layer alone scatters in the resist film in its high energy state, the electron beam seems less effective to achieve a high sensitivity (to improve the sensitivity of the resist film). The high sensitivity was achieved by making a multilayer structure comprising, for example, the scattering layer 40a and the auxiliary layer 40b and using the effect of reducing the energy of the scattered beam.

As an experiment to check the embodiment shown in Fig. 5, an example of the master disc was prepared by forming a surface layer area having a chromium layer with a thickness of 100 nm and an Au scattering layer with a thickness of 300 nm laminated in this order on the silicon substrate main body and then forming a resist film with a predetermined thickness on the surface layer area. A line recording experiment at the recording speed of 0.7 to 1.4 m/s was conducted with an electron beam by irradiating an acceleration voltage of 50 kV onto the resist film of the master disc by an electron beam recorder.

To confirm the effect of this embodiment, a comparative master disc having only a resist film formed on the silicon substrate was prepared. This master disc was also exposed with an electron beam and subject to a line recording experiment under the same conditions as those for the master disc example. The high-sensitivity achieving effects of both master discs were compared with each other by comparing the line widths of both master discs. The results are shown in Table 4 below.

Table 4

| [m/s] Recording speed | [nm] | |
|---|---|---|
| | comparative master disc | Master disc example |
| 0.7 | 133 | 175 |
| 0.8 | 122 | 148 |
| 0.9 | 105 | 136 |
| 1.0 | 98 | 112 |
| 1.1 | 87 | 102 |
| 1.2 | 73 | 94 |
| 1.3 | 70 | 91 |
| 1.4 | 67 | 84 |

As apparent from Table 4, the line width of the master disc example was increased as compared with that of the comparative master disc under the same recording condition. That is, Table 4 showed that the surface layer area of the substrate of the example had a high-sensitivity effect of increasing the energy density of the electron beam at the exposed portion of the resist film. As a result, it is possible to separate the exposed portion and non-exposed portion by a boundary surface with a sharp shape and achieve high density recording.

Although the foregoing description of the example has been given of the preparation of an optical disc substrate, the present invention can prepare a substrate having pre-patterns (servo patterns) formed concentrically and form a magnetic recording layer on that substrate to prepare a magnetic disc or a platter of a hard disc. The present invention which has been explained in case of sequential exposure with an electron beam by an electron beam recorder, the invention can also be applied to full exposure.

It is understood that the foregoing description and accompanying drawings set forth the preferred embodiments of the invention at the present time. Various modifications, additions and alternative designs will, of course, become apparent to those skilled in the art in light of the foregoing teachings without departing from the spirit and scope of the disclosed invention. Thus, it should be appreciated that the invention is not limited to the disclosed embodiments but may be practiced within the full scope of the appended claims.

**Claims**

1. An electron beam recording substrate where electron beam information recording is carried out, **characterized by** comprising: a substrate main body; a resist film relative to the substrate main body; and a surface layer area made of a material that suppresses enlargement of a scattering distribution diameter of electrons spread inside by irradiation of an electron beam from a resist film side.

2. The electron beam recording substrate according to claim 1, wherein the substrate main body is positioned on a side opposite to said resist film with respect to said surface layer area.

3. The electron beam recording substrate according to claim 1, wherein said electron beam recording substrate is made only of a same material as said material for said surface layer area.

4. The electron beam recording substrate according to claim 1, wherein said surface layer area is made of a material containing at least one of elements with atomic numbers 21 to 36, 38 to 54 and 56 to 83 by 50 wt% or greater.

5. The electron beam recording substrate according to claim 1, wherein said surface layer area is made of a material containing at least one of elements with atomic numbers 73 to 79 by 50 wt% or greater.

6. The electron beam recording substrate according to claim 2, wherein said surface layer area is made of a material containing at least one of elements with atomic numbers 73 to 79 by 50 wt% or greater and said substrate main body is made of a material containing at least one of elements with atomic numbers 13, 14, 21 to 36, 38 to 54, 56, 57, 72 and 80 to 83 by 50 wt% or greater.

7. The electron beam recording substrate according to claim 2, wherein said surface layer area is comprised of a plurality of thin films.

8. The electron beam recording substrate according to claim 6, wherein that thin film in said plurality of thin films which is in contact with said resist film is made of a material containing at least one of elements with atomic numbers 73 to 79 by 50 wt% or greater and those other than said thin film contacting said resist film are made of a material containing at least one of elements with atomic numbers 21 to 36, 38 to 54, 56, 57, 72 and 80 to 83 by 50 wt% or greater.

9. The electron beam recording substrate according to claim 6, wherein that thin film in said plurality of thin films which is in contact with said resist film is made of a material containing at least one of elements with atomic numbers 21 to 36, 38 to 54, 56, 57, 72 and 80 to 83 by 50 wt% or greater and those other than said thin film contacting said resist film are made of a material containing at least one of elements with atomic numbers 73 to 79 by 50 wt% or greater.

# FIG. 1

# FIG.2

# FIG.3

ELECTRON BEAM

# FIG.4

ELECTRON BEAM

# FIG.5

# FIG.6